# EUROPEAN PATENT APPLICATION

(11) **EP 2 827 366 A1**
(43) Date of publication of application: **21.01.2015**
(21) Application number: 13177056.2
(22) Date of filing: 18.07.2013
(51) Int. Cl.: H01L 25/07, H01L 23/00

(54) **Power semiconductor module**

(71) Applicant: ABB Technology AG, 8050 Zürich (CH)
(72) Inventor: Wildner, Franz, 5064 Wittnau (CH)
(74) Representative: ABB Patent Attorneys

(57) **Abstract**

The present invention relates to a spring element (10) for a power semiconductor module (30) having an upper contact area (12) for directly or indirectly connecting the spring element (10) to a load plate (32) and having a lower contact area (14) for directly or indirectly connecting the spring element (10) to a power semiconductor device (34), wherein the spring element (10) has a plurality of grooves (16, 18) located along the circumference and restricted with respect to the circumference, wherein the grooves (16, 18) provide a spring deflection of the spring element (10). Such a spring element (10) provides for a stable and reliable failure mode and further has an improved and cost-saving producibility. The present invention further relates to a power semiconductor module (30) comprising at least one spring element (10).

## Description

### Technical Field

The present invention relates to a power semiconductor module. The present invention particularly relates to a power semiconductor module having an improved short circuit failure mode by having the capability of securely falling into a stable electrical short circuit after a failure event.

### Background Art

Modern high voltage power circuits must be able to block voltages exceeding 100 kV and carry currents over 1 kA when in the on-state. Series and parallel connections of many semiconductor chips are required to form phase legs with these capabilities. Switch modules are made of many parallel chips. Mechanically clamping of switch modules in series makes compact and cost-efficient phase legs.

Phase legs might be built of thousands or ten-thousands of IGBT chips. A failure of any single chip typically causes a system failure. Thus, a large number of chips involved increases the likelihood of catastrophic system failures which must be avoided under any circumstances.

In the case of high power semiconductor modules it has been found that a defect can lead to the formation of an electrical short circuit. With large chip areas, this short circuit remains stable over a long time. If, for example, redundant thyristors are provided in a stack of thyristors connected in series, the remaining, intact thyristors withstand the voltage during the switched-off phase, and the stack remains operative. Defective thyristors can be replaced subsequently in the course of planned servicing work.

In a thyristor module, for example, the semiconductor, that is to say the silicon (Si), is in mechanical and electrical contact with and arranged between two molybdenum wafers. Silicon has a melting point of 1420°C, wherein that of molybdenum is higher, and the intermetallic compounds of silicon and molybdenum have a still higher melting point. Thus, in the event of a defect, the silicon melts locally first of all and, as current flows, it forms a conductive channel composed of molten silicon over the entire thickness of the semiconductor. This defect zone can propagate and/or move, but will only affect a small part of the chip area. In hermetically sealed housings, the molten silicon does not oxidize but reacts with molybdenum to form a type of powder. This process continues until all the silicon has been consumed, and may possibly extend over years.

In contrast to thyristor semiconductor components, insulated gate bipolar transistor (IGBT) chips, for example, are not produced as large-area units and, normally, a plurality of small-area individual chips are arranged isolated and alongside one another in the insulated gate bipolar transistor modules.

It has been found that no stable short circuits of the type described above can be expected with insulated gate bipolar transistor modules, for example. This is primarily due to the reduced area of the individual chips, and the small silicon volume. The pseudo-stable phase of a short circuit lasts for only a few hours in this case. Furthermore, the housings are often deliberately not hermetically sealed, so that the molten silicon can react with oxygen and form insulating silica (SiO₂). Without any stable short-circuit path in the defective chip, the worst-case situation which can arise is as follows. If the remaining chips in a module, including the actuation, are still intact, they can withstand voltage during the switched-off phase. The current is then forced through the defective chip and, at voltages up to the break down voltage of the intact chips, the current may lead to a plasma being formed, with a very high power density. This results in the entire module being destroyed.

To avoid this problem, known from EP 0 989 611 B1 is a power semiconductor module which is formed from small-area individual chips and in which a short circuit of an individual chip does not lead to total failure of the module. According to this prior art, a layer composed of a suitable material, for example, silver or aluminium, is brought into direct contact with one or both of the main electrodes of the silicon semiconductor. The material of this layer may form an eutectic alloy with silicon. In the event of a short circuit, the entire sandwich structure is heated and, once the melting point of the eutectic mixture is reached, a conductive melt starts to form on the contact surface between the said layer and the silicon. This zone can then expand over the entire thickness of the semiconductor, and thus form a metallically conductive channel. A sufficient electric contact is thereby provided by means of an electric contact piston, or load pin, respectively.

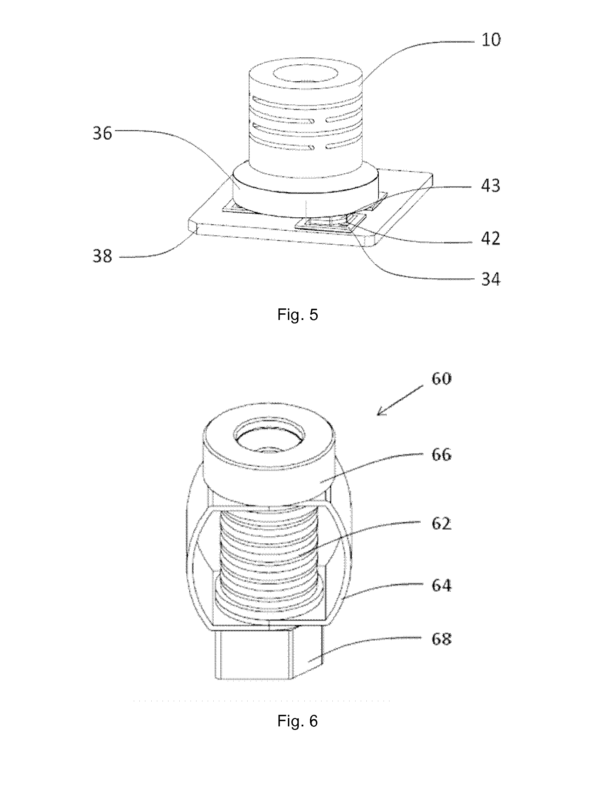

A load pin 60 according to the prior art is shown in figure 6. According to figure 6, the load pin 60 is formed from central disk springs 62 which are surrounded by a current bracket 64. At the top of the load pin 60 and connected to the current bracket 64 is a load contact pin 66, whereas below the current bracket 64 and connected thereto is a emitter contact 68.

However, the solutions for providing a secure short circuit failure mode known from the prior art still have potential for improvements.

### Disclosure of Invention

It is an object of the present invention to provide a power semiconductor module having an improved short circuit failure mode and/or which is cost-saving to form.

This object is achieved by the independent claims 1 and 10. Advantageous embodiments are given in the dependent claims.

In particular, the present invention provides a spring element for a power semiconductor module having an upper contact area for directly or indirectly connecting the spring element to a load plate and having a lower contact area for directly or indirectly connecting the spring element to a power semiconductor device, wherein the spring element has a plurality of grooves located along the circumference and restricted with respect to the circumference, wherein the grooves provide a spring deflection of the spring element.

Such a spring element provides for a stable and reliable failure mode and further has an improved and cost-saving producibility.

A spring element like described above may thereby particularly serve to be mounted in a current path of a power semiconductor module being spring biased. It may thereby be provided that each power semiconductor module comprises a plurality of power semiconductor devices, or chips, respectively, which are connected parallel or in series in order to form phase legs with superb capabilities. For example, phase legs may be built of thousands or ten-thousands of IGBT chips. In order to prevent a whole system failure due to a failure of one chip, security measures are provided.

Such security measures may be based on the fact that, in case a power semiconductor device fails, heat is generated through a formed short circuit. The generated heat leads to an alloying material, such as aluminium or silver, which may be present as a thin platelet sitting on top of an emitter electrode of a power semiconductor device, to melt and to form an eutectic alloy together with the silicium of the chip. Such a process may be called "alloying". This process may provide a robust and stable low resistance path which locally leads to a closed circuit which can accept the full current load over even extended periods of time. This working mode may be called a short circuit failure mode (SCFM). Due to the fact that the spring element is spring loaded against the power semiconductor device, or provides a spring load, respectively, the spring pressure of the spring element forces the liquid, i.e. the molten material to flow away. Consequently, the spring element may release in the direction towards the chip and thus parallel to the current path thereby forming a low resistance contact.

The spring element thus acts as an electrically conducting high compression load device and serves to compensate for the mechanical displacement on top of a chip, or a power semiconductor device, respectively, when the short circuit failure mode (SCFM) is formed.

The spring element like described above thereby has significant advantages with regard to solutions known from the prior art.

In fact, the spring element is very well adaptable to the desired application and the respective demands. For example, the spring force as well as the spring deflection may be easily adapted by just arranging the position of the grooves, the amount of grooves as well as the thickness of the respective grooves. This adaption may thereby be done mechanically and thus in an automated and thereby highly exact and reliable process allowing the spring element to be produced in a very exact and reliable manner. This adaption may thus secure that the spring element has the properties which are required for the special application and thus significantly reduces the danger of complete system failures in case a failure mode occurs.

Further, due to the fact that the spring deflection of the spring element is provided just by introducing grooves into the element as such, the spring element is capable of carrying high amounts of current and thus provides a high current capability. The current capability is thereby easily adaptable by adapting the number and especially the thickness of the grooves like stated above. This is particularly due to the fact that the thinner the grooves are, the lower is the electric resistance and thus the higher is the current carrying capability. Therefore, in order to meet the suitable requirements regarding current carrying capability, a compromise has to be found between the spring deflection and spring force on the one side and additionally to the current carrying capability on the other side.

The easy adaption of the current carrying capability thereby allows the spring element to serve for an especially secure and reliable short circuit failure mode thereby further allowing the service intervals as well as the systems failure due to the failure of single chips to be significantly reduced.

A further adaption which may easily be made by providing the above defined spring element may be seen in the area or position, respectively, of spring deflection and thus of the direction of the spring force. In detail, the positions of the grooves which are restricted with respect to the circumference of the spring element define the compressibility as well as spring force of the spring element. Thus, by adapting the exact position as well as the dimension along the circumference, the area of deflection may easily be adapted. Apart from that by defining the number of grooves which are shifted to one another with regard to the respective circumferential position, the number of areas of deflection of the spring element may easily be adapted. This allows for a further superb adaptability of the spring element to the desired application.

The exact form and the dimension of the spring element might thereby serve to adapt the spring element for the respective fill factor in the module and thus for the number of power semiconductor devices, or chips, respectively, one spring element is connected to. In fact, the form such as particularly the circumferential form, or diameter, respectively, as well as the dimension of the spring element may be adapted during the production of such a spring element without problems. Particularly in dependence of the exact form and dimension of the spring element provided, one single spring element might serve to contact either one, two, or more than two, such as three, power semiconductor devices, or chips, respectively. Therefore, the spring element may be introduced not only in newly designed power semiconductor modules, but may also be introduced into existing power semiconductor modules.

Apart from that, the spring element like described above has significant advantages with regard to producibility. In fact, the spring element has a strongly reduced number of parts compared to the solutions of the prior art which allows an easy assembly of the spring element. Further, the assembly of the spring element into a power semiconductor module may as well be very easy. This allows the production of a spring element and as well of a power semiconductor module to provide significant advantages with regard to costs. A further advantage regarding costs may be due to the fact that one spring element may serve to contact a plurality of power semiconductor devices, because of which the total number of spring elements per power semiconductor module may be significantly decreased with regard to respective contact elements known from the prior art. This is especially advantageous taking into consideration the huge number of power semiconductor devices which are present in power semiconductor modules. Therefore, the savings of costs are especially significant by using one or more spring elements like defined above.

Furthermore, a spring element like described above may provide a reduced number of dry contacts further improving the current carrying capability and thus serving for an improved short circuit failure mode and thus for a reduced danger of a complete system failure based on the failure of single power semiconductor devices, or chips, respectively.

Next to that, the spring element like described above may provide a much higher spring force compared to coil springs. In fact, the achieved spring forces are only achievable with a large amount of disc springs and thus when providing a much more complicated construction.

To summarize, a spring element for mounting in a power semiconductor module provides low costs, an easy assembly and a stable and robust short circuit failure mode thereby reducing the danger of a complete system failure and reducing potential service intervals.

According to an embodiment at least two grooves are shifted with respect to each other in a circumferential direction and are located such that at least two spring deflection areas are provided. This embodiment shall particularly mean that at least one or both termini of the grooves are shifted compared to the respective termini of the further groove. A circumferential direction may thereby particularly mean a direction having an essentially right angle with respect to the direction protruding from the upper contact area to the lower contact area and thus having essentially a right angle compared to the main spring force. According to this embodiment the short circuit failure mode may be reached very fast and unique due to the fact that a spring tension may act very unique to the whole surface of the chip, or to all chips present, depending on the dimensions of the spring element. This is due to the fact that the spring force may be distributed homogeneously over the whole spring element. This is especially important taking into consideration the objective of the spring element. With this regard, the spring element exceeds a force in the direction towards the chip when the alloying material melts. Thus, in case the material melts only in part at the beginning, the short circuit failure mode may anyhow be securely be formed in case only one chip is contacted. On the other hand, in case a plurality of chips is contacted, a respective force may be exceeded to any of the present chips so that independently of which chip fails, the short circuit failure mode may be formed especially safe and reliable.

According to a further embodiment the spring element comprises a central channel protruding in the direction from the upper contact area to the lower contact area. Accordingly, in case a central channel protruding in the direction from the upper contact area to the lower contact area is provided, the spring element may have a ring-shaped form or a comparable form. According to this embodiment, the weight of the spring element may be significantly reduced, which may be especially advantageous with regard to mobile applications, thereby anyhow allowing a suitable current carrying capability. Further, due to the fact that the spring element is no compact device, the spring forces may be provided much easier and further much more effective due to the fact that the elasticity may be significantly enhanced. Thus, next to achieving a weight reduction, the spring forces may be enhanced and adapted especially exactly.

According to a further embodiment the spring element is formed as a one-piece unit. This embodiment allows further advantages with respect to producibility. In detail, the spring element may be formed from a compact material block just by introducing the respective grooves and, if provided, the channel. Thus, the spring element may be formed by fully automated processes in essentially one step allowing the spring element to be formed especially cost-saving. This is especially advantageous taking into consideration the enormous number of spring elements required for common phase legs, or power semiconductor modules, respectively.

According to a further embodiment the spring element is formed from copper or is based on copper. According to this embodiment, copper as a base material and thus especially copper alloys such as copper-beryllium, copper-chrome, brass or bronze may have electrical and thermal suitable properties which are required for forming the spring element like described above. In detail, copper has a good electrical conductivity allowing the spring element to have a superb current carrying capability and especially copper alloys may combine this property with the required mechanical properties such as spring forces. In combination to the electrical conductivity, however, copper additionally has mechanical properties allowing spring forces to be provided and thus allowing a suitable spring preloading against the power semiconductor device. Therefore, it is secured that in case a failure of a power semiconductor device arises, a secure and reliable short circuit failure mode may be achieved.

According to a further embodiment the spring element is formed with a circular, square, oval, or rectangular cross-section. According to this, the spring element may easily be adapted to the defined requirements of the present application. In detail, especially in case the spring element is configured for contacting a plurality of power semiconductor devices, the form of the spring element may be adapted to both the number of the power semiconductor devices and the respective position of the latter. As a result, the spring element may easily be introduced into existing patterns of power semiconductor devices. Thus, by using one or more spring elements for contacting a plurality of power semiconductor devices, the arrangement of the latter does not have to be influenced. Further, especially in case the spring element contacts a plurality of power semiconductor devices, this may be realized via a yoke which is positioned between the spring element and the power semiconductor devices. The yoke may thus as well have the above-defined forms, wherein the form of the yoke may be the same or different compared to that of the spring element.

According to a further embodiment the lower contact area is formed from a centrally located constriction. This embodiment allows an especially stable and reliable short circuit failure mode. In detail, a constriction allows compensating angular movements during the formation of a short circuit failure mode by a plastic deformation. This may be advantageous due to the fact that in case a short circuit failure mode occurs, the spring element or a yoke, for example, will potentially slightly tilt and the constriction is capable of being plastically deformed. With this regard, it may be advantageous that the constriction may be formed from copper due to the fact that copper is a material which allows a suitable plastic deformation at the conditions at which a short circuit failure mode will appear and further has a suitable electric conductibility. A constriction shall thereby particularly mean a part of the spring element being reduced with regard to the dimensions such as diameter compared to the largest outer diameter of the spring element as such. The constriction should reach the yield stress of either the yoke or the spring material when an SCFM occurs. It may thus be formed as a circular pin, for example having dimensions in the non-limiting range of 2 to 4 mm.

According to a further embodiment the spring deflection of the whole spring element has a dimension in the range of ≤ 3mm, in particular in the range of ≥ 1 mm to ≤ 2mm. This embodiment allows a suitable compressibility of the spring element which is sufficient for high power applications. Further, the current carrying capability may be provided in an amount in order to withstand even high currents occurring in case the spring element has to carry the overall load current which will be commutated through the failed chip assembly and thus through the spring element even for high power applications. In a mode in which the spring element is mounted in a power semiconductor module, the grooves may be at least partly closed in order to achieve the desired spring bias and spring deflection, respectively.

According to a further embodiment the elastic resilience, or the spring force, respectively, of the spring is in the range of ≥ 200 N to ≤ 5000 N, particularly at ≥ 500 N to ≤ 1000 N, the named forces acting on each chip, or power semiconductor device, respectively. Such spring forces allow forming an especially secure and reliable short circuit failure mode thereby allowing a current path with an especially low resistance. Thus, this application may be particularly advantageous for high power applications.

With regard to further technical features and advantages of the spring element, it is referred to the following description of the power semiconductor module, the figures and the description of the figures.

The present invention further relates to a power semiconductor module, comprising at least one spring element, in particular a plurality of spring elements, like defined above.

In detail, the power semiconductor device may comprise a baseplate which is provided with metallizations particularly being electrically insulated against the baseplate, on which metallizations power semiconductor devices, such as in a non-limiting manner IGBTs or diodes, may be positioned as it is generally known in the art. Above the power semiconductor devices and particularly connected to the emitter electrodes of the latter, an alloying material may be provided which, in case of a failure, melts and forms an alloy with the silica of the power semiconductor device. The alloying material is in turn directly or indirectly connected to the lower contact area of the spring element, wherein the upper contact area of the spring element may be directly or indirectly connected to a load plate. A direct connection shall thereby mean a connection without further components there between, whereas an indirect connection shall mean a connection of two parts having further one or more components there between.

In case of a failure of a power semiconductor device, or a chip, respectively, heat is generated through a formed short circuit. The generated heat leads to the alloying material positioned on top of an emitter electrode of the power semiconductor device to melt and to form an eutectic alloy together with the silicium of the chip. This process may provide a robust and stable low resistance path which locally leads to a closed circuit which can accept the full current load over even extended periods of time. Due to the spring load of the spring element, which is spring loaded against the chip, the spring pressure of the spring element forces the liquid, i.e. the molten material to flow away. Consequently, the spring element may release in the direction towards the chip and thus parallel to the current path.

The power semiconductor module having a spring element like described above may be producible with low costs and with an easy assembly. Further, a stable and robust short circuit failure mode may be formed reducing the danger of a complete system failure and reducing potential service intervals. Further, the spring element may serve to compensate any misalignments, non-planarities and height differences of different parts of the module.

According to an embodiment the power semiconductor device comprises at least two power semiconductor devices onto which at least two power semiconductor devices a yoke is provided, and wherein one spring element is located between said yoke and a load plate. According to this embodiment, the costs of the module may be further reduced due to the fact that one spring element may serve as a security measure for two or more and thus for a plurality of power semiconductor devices. A reduction of spring elements may thereby be especially advantageous taking into consideration the huge amount of spring elements being required for power semiconductor modules depending on the application. Further, next to a reduction of costs the weight may as well be significantly reduced which may be advantageous particularly for mobile applications.

Generally, the yoke provides two functionalities. At first, the yoke may serve for a homogeneous distribution of the spring force. Further, the yoke may provide protection against potentially occurring electric arcs.

According to a further embodiment at least one power semiconductor device is provided having an alloying material in vicinity to a silicium surface, wherein the alloying material is chosen from the group consisting of noble metals such as aluminum, gold, silver, or alloys comprising noble metals, such as silver, aluminum, gold, or tin. Especially these materials are preferred alloying materials due to the fact that these materials form an alloy with the silicium of the power semiconductor device which alloy has a high electric conductivity. Further, the formed alloy may build stable contacts allowing the formed short circuit failure mode to be stable even when carrying large currents over a long period of time.

With regard to further technical features and advantages of the power semiconductor module, it is referred to the description of the spring element, the figures and the description of the figures.

### Brief Description of Drawings

These and other aspects of the invention will be apparent from and elucidated with reference to the embodiments described hereinafter.

In the drawings:

Fig. 1 shows an embodiment of a spring element according to the invention;

Fig. 2 shows a further embodiment of a spring element according to the invention;

Fig. 3 shows a side view of an embodiment of a power semiconductor module according to the invention comprising a spring element according to the invention;

Fig 4 shows a view of a further embodiment of a power semiconductor module according to the invention comprising a plurality of spring elements according to the invention from above;

Fig. 5 shows a view of a part of a further embodiment of a power semiconductor module according to the invention comprising a plurality of spring elements according to the invention from above;
and

Fig. 6 shows a load pin according to the prior art.

### Detailed Description of the Invention

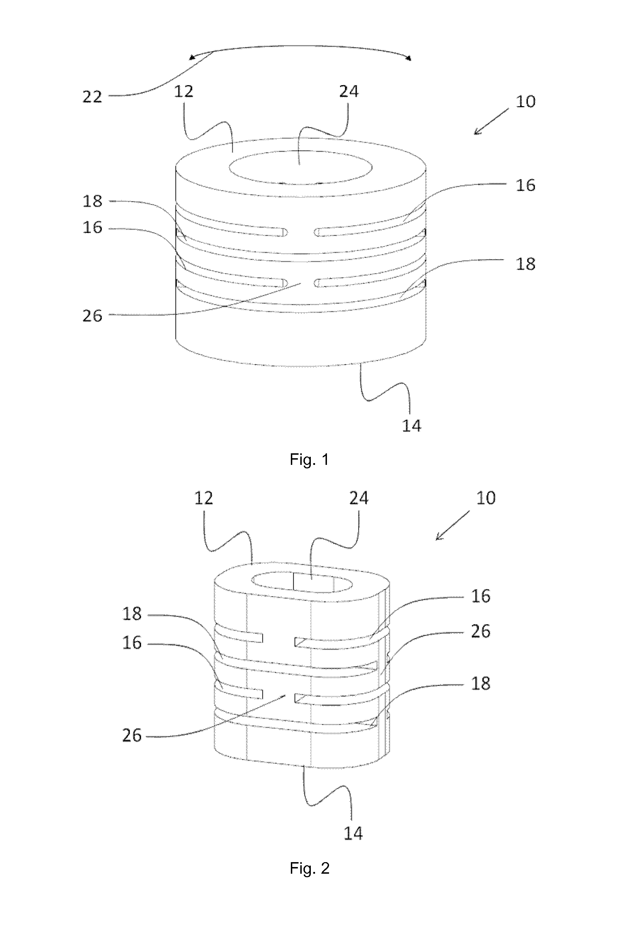

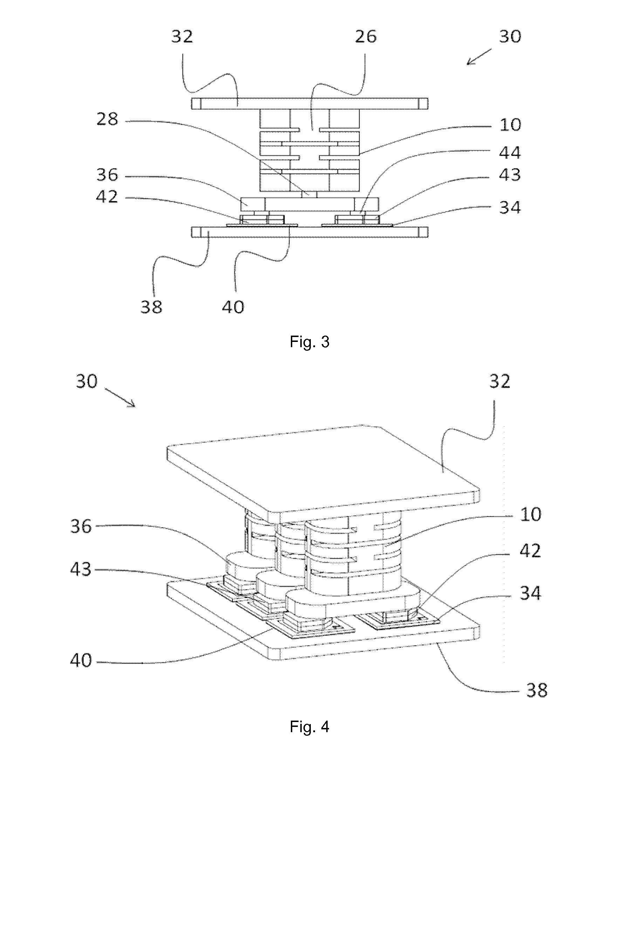

Fig. 1 shows an embodiment of a spring element 10 according to the invention. The spring element 10 is particularly suitable for mounting into a power semiconductor module 30 and has as objective to form a stable and reliable short circuit failure mode. The location of the spring element 10 in a power semiconductor module 30 is shown in the following figures 3 to 5.

The spring element 10 according to figure 1 has a round cross-section and comprises an upper contact area 12 for directly or indirectly connecting the spring element 10 to a load plate 32 and having a lower contact area 14 for directly or indirectly connecting the spring element 10 to a power semiconductor device 34 like will be described in detail down below.

The spring element 10 comprises a plurality of grooves 16, 18 located along the circumference and restricted with respect to the circumference, which is indicated by the arrow 22. A groove 16, 18 shall particularly mean a channel which may be open in one direction and which is formed in a compact material part.

It is shown in figure 1 that the grooves 16 for example, have the length of nearly the whole circumference, just leaving two ligaments 26 of the material of the spring element 10 there between. The ligaments 26 may have a width of ≥ 1 mm to ≤ 5 mm. Further, grooves 18 are located rectangular to the grooves 16. Therefore, it may be seen that at least two grooves 16, 18 are shifted with respect to each other in a circumferential direction and are located such that at least two spring deflection areas are provided.

According to figure 1, two pairs of grooves 16, 18 are provided being shifted in an angle of 90°, resulting in four beams to be formed which provide the capability of the spring element to be elastically deformed. Depending on the number of grooves 16, 18 or the pair of grooves, respectively, further shifting angles are possible, such as 60° when providing three pairs of grooves 16, 18.

Further, the grooves 16, 18 provide a spring deflection of the spring element 10. Respective spring deflection areas are thus defined by the length of the grooves 16, 18. Thus, a spring deflection area is defined by grooves 16, 18 lying underneath each other. In detail, the spring deflection of a spring deflection area of the whole spring element 10 has a dimension in the range of ≤ 3mm, in particular in the range of ≥ 1 mm to ≤ 2mm, which may be realized by the overall thickness of all grooves 16, 18 present in one spring deflection area. The respective spring deflection may be valid for all spring deflection areas. Further and with regard to the spring force, the latter may lie in a range of ≥ 200 N to ≤ 5000 N, particularly at 1000 N.

It may further be seen that the spring element 10 comprises a central channel 24 protruding in the direction from the upper contact area 12 to the lower contact area 14. Further, the spring element 10 is formed as a one-piece unit and may be formed, for example, from copper or may preferably be based on copper.

The spring element 10 according to figure 2 corresponds to the one shown and described in figure 1 because of which it is referred to the respective description. However, referring to the form of the spring element 10 according to figure 2, the latter has an oval cross-section.

In figure 3, a power semiconductor module 30 is shown which comprises at least one spring element 10 like described above. With respect to the spring element 10 it is referred to the above description of figures 1 and 2.

It is shown in figure 3 that the spring element 10 is located between a load plate 32 and a yoke 36. The yoke 36 serves for distributing the load over a two or more power semiconductor devices 34.The yoke 36 is thereby contacted via a locally arranged constriction 28 which may be part of the spring element 10 and thus may be part of the respective one-piece unit. The yoke 36 transfers the load of the spring element 10 to two power semiconductor devices 34, which may be located on metallizations 40 on a baseplate 38. In detail, the yoke 36 is connected to the power semiconductor devices 34 via a constriction 44 and via the alloying material 42, which may be formed as an aluminum platelet, for example. Above the alloying material, a refractory material 43 such as a refractory platelet may be provided. The arrangement according to figure 3 is a so-called double load assembly due to the fact that one spring element 10 contacts two power semiconductor devices 34, or chips, respectively.

The top load plate 32 and the baseplate 38 are mechanically clamped up to well-defined loads, for example serving for the spring force. The load plate 32 may serve as an electrical connection for the load current. A further electrically insulating case, not shown as such, may serve as a spacer.

Figure 4 shows a further embodiment of a power semiconductor device 30. The arrangement according to figure 4 corresponds to the embodiment of figure 3, because of which it is referred to the respective description in its entirety. Further, the arrangement according to figure 4 comprises three spring elements 10 having an oval cross-section, each of which in turn contacts two power semiconductor devices 34 via one respective yoke 36. This, figure 4 shows an array of double load assemblies like described above.

Figure 5 shows a part of a further embodiment of a power semiconductor device 30. The arrangement according to figure 5 corresponds to the embodiment of figure 3, because of which it is referred to the respective description in its entirety. According to figure 5, however, the spring element 10 as well as the yoke 36 have a round cross-section and is adapted to contact three power semiconductor devices 34. This arrangement may thus be called a triple load assembly.
While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: spring element
- 12: upper contact area
- 14: lower contact area
- 16: groove
- 18: groove
- 22: arrow
- 24: central channel
- 26: ligament
- 28: constriction
- 30: power semiconductor module
- 32: load plate
- 34: power semiconductor device
- 36: yoke
- 38: baseplate
- 40: metallization
- 42: alloying material
- 43: refractory material
- 44: constriction
- 60: load pin
- 62: disk springs
- 64: current bracket
- 66: contact pin
- 68: emitter contact

## Claims

1. Spring element for a power semiconductor module (30) having an upper contact area (12) for directly or indirectly connecting the spring element (10) to a load plate (32) and having a lower contact area (14) for directly or indirectly connecting the spring element (10) to a power semiconductor device (34), wherein the spring element (10) has a plurality of grooves (16, 18) located along the circumference and restricted with respect to the circumference, wherein the grooves (16, 18) provide a spring deflection of the spring element (10).

2. Spring element according to claim 1, wherein at least two grooves (16, 18) are shifted with respect to each other in a circumferential direction and are located such that at least two spring deflection areas are provided.

3. Spring element according to any of the preceding claims, wherein the spring element (10) comprises a central channel (24) protruding in the direction from the upper contact area (12) to the lower contact area (14).

4. Spring element according to any of the preceding claims, wherein the spring element (10) is formed as a one-piece unit.

5. Spring element according to any of the preceding claims, wherein the spring element (10) is formed from copper or is based on copper.

6. Spring element according to any of the preceding claims, wherein the spring element (10) is formed with a circular, square, oval, or rectangular cross-section.

7. Spring element according to any of the preceding claims, wherein the lower contact area (14) is formed from a centrally located constriction (28).

8. Spring element according to any of the preceding claims, wherein the spring deflection of the whole spring element (10) has a dimension in the range of ≤ 3mm, in particular in the range of ≥ 1 mm to ≤ 2mm.

9. Spring element according to any of the preceding claims, wherein the elastic resilience of the spring element (10) is in the range of ≥ 200 N to ≤ 5000 N.

10. Power semiconductor module, comprising at least one spring element (10) according to any of the preceding claims.

11. Power semiconductor module according to claim 10, wherein the power semiconductor module (30) comprises at least two power semiconductor devices (34) onto which at least two power semiconductor devices (34) a yoke (36) is provided, and wherein one spring element (10) is located between said yoke (36) and a load plate (32).

12. Power semiconductor module according to any of claims 10 or 11, wherein at least one power semiconductor device (34) is provided having an alloying material (42) in vicinity to a silicium surface, wherein the alloying material (42) is chosen from the group consisting of noble metals such as aluminum, gold, silver, or alloys comprising noble metals, such as silver, aluminum, gold, or tin.
